# EUROPEAN PATENT APPLICATION

(11) **EP 4 832 707 A1**
(43) Date of publication of application: **28.10.2026**
(21) Application number: 24908154.8
(22) Date of filing: 20.12.2024
(51) Int. Cl.: H10H 29/852, H10H 29/80, H10H 29/14, H10H 20/84, H10H 20/852

(54) **LIGHT EMITTING MODULE AND DISPLAY DEVICE INCLUDING SAME**

(30) Priority: 21.12.2023 US 202363613159 P; 19.12.2024 US 202418986942
(71) Applicant: Seoul Viosys Co., Ltd., Ansan-si, Gyeonggi-do 15429 (KR)
(72) Inventor: CHOI, Eunmi, Ansan-Si Gyeonggi-do 15429 (KR)
(74) Representative: Isarpatent
(86) International application number: PCT/KR2024/020815
(87) International publication number: WO 2025/135872

(57) **Abstract**

A light emitting apparatus includes a substrate, a cover layer disposed on an upper surface of the substrate and forming at least one opening that exposes at least a region of the upper surface of the substrate, a light emitting device disposed on the upper surface of the substrate exposed through the opening, and a molding layer covering the cover layer and the light emitting device.

## Description

### [Technical Field]

Embodiments of the disclosed technology relate to a light emitting module and a display apparatus including the same, and more particularly to a light emitting module including a plurality of light emitting diode chips and a display apparatus including the same.

### [Background Art]

A light emitting device is a semiconductor device that employs a light emitting diode which is an inorganic light source, and is used in various fields, such as a display apparatus, vehicular lamps, and general lighting. Light emitting diodes are rapidly replacing conventional light sources due to their advantages including long lifespan, low power consumption, and fast response time.

Typical light emitting diodes have mainly been used as a light source for a backlight unit in a display apparatus, and display apparatuses configured to directly implement images using light emitting diodes have been developed in recent years. Such display apparatuses are also called micro-LED displays.

Typically, a display apparatus realizes various colors using a mixture of blue, green, and red colors. To implement various images, the display apparatus includes a plurality of pixels each including blue, green, and red subpixels. A color of a certain pixel is determined through colors of these subpixels and an image is implemented through combination of these subpixels.

In a micro-LED display, micro-LEDs are arranged on a two-dimensional plane corresponding to each subpixel, which requires a large number of micro-LEDs to be placed on a single substrate. However, micro-LEDs have a very small size of, for example, 200 micrometers or even 100 micrometers or less, causing various problems.

In particular, when molding a large number of micro-LEDs mounted on a substrate through a typical molding method in which a thermosetting resin is applied to the substrate and cured, there can be various problems, such as reduction in luminous efficiency and difficulty in hardness increase, due to a molding layer.

### [Disclosure]

### [Technical Problem]

Embodiments of the disclosed technology provide a light emitting apparatus with high luminous efficiency and improved color clarity, and a display apparatus including the same.

### [Technical Solution]

In accordance with one aspect of the disclosed technology, a light emitting apparatus includes: a substrate; a cover layer disposed on an upper surface of the substrate and forming at least one opening exposing at least a region of the upper surface of the substrate; a light emitting device disposed on the upper surface of the substrate exposed through the opening; and a molding layer covering the cover layer and the light emitting device.

In one embodiment, the cover layer may include a black pigment.

In one embodiment, the light emitting device may include a transparent substrate and a semiconductor layer disposed on one surface of the transparent substrate and generating light.

In one embodiment, the cover layer may have a greater thickness than the semiconductor layer.

In one embodiment, the opening may have a smaller size than the light emitting device in plan view.

In one embodiment, the molding layer may include: a first molding layer covering at least a region of a side surface of the light emitting device while exposing an upper surface of the light emitting device; and a second molding layer covering the upper surface of the light emitting device and the first molding layer.

In one embodiment, the first molding layer may include at least one of a light reflective material or a light absorbing material.

In one embodiment, the second molding layer may be a light transmitting layer.

In one embodiment, an upper surface of the first molding layer disposed between two adjacent light emitting devices may form a concave surface.

In one embodiment, a thickness from the upper surface of the substrate to the lowest point of the concave surface of the first molding layer may be greater than a thickness from the lowest point of the concave surface of the first molding layer to an upper surface of the second molding layer.

In one embodiment, a thickness of the cover layer may be greater than a thickness from the lowest point of the concave surface of the first molding layer to the highest point of the concave surface of the first molding layer.

In one embodiment, a long axis width of the light emitting device may be greater than a thickness from the upper surface of the light emitting device to an upper surface of the second molding layer.

In one embodiment, three light emitting devices configured to emit light with different peak wavelengths and disposed in a first direction on a plane may form one pixel.

In one embodiment, the light emitting apparatus may include a plurality of pixels arranged in a matrix in the first direction and a second direction perpendicular to the first direction.

In one embodiment, a maximum distance between two light emitting devices at opposite sides within the pixel in the first direction may be greater than the shortest distance between two adjacent pixels in the second direction.

In one embodiment, a separation distance between two adjacent light emitting devices within the pixel in the first direction may be smaller than the shortest distance between two adjacent pixels in the first direction.

### [Advantageous Effects]

Embodiments of the disclosed technology provide a light emitting apparatus with high luminous efficiency and improved color vividness, and a display apparatus including the same.

### [Description of Drawings]

FIG. 1 is a plan view of a display apparatus according to the disclosed technology.
FIG. 2 is a view of a light emitting diode constituting the display apparatus shown in FIG. 1.
FIG. 3A and FIG. 3B are side views of light emitting devices disposed in a display apparatus according to one embodiment of the disclosed technology.
FIG. 4 is a side view of light emitting devices disposed in a display apparatus according to another embodiment of the disclosed technology.
FIG. 5A and FIG. 5B are a partial side view and a partial plan view of a display apparatus according to a further embodiment of the disclosed technology, respectively.
FIG. 6 is a partial side view of a display apparatus according to yet another embodiment of the disclosed technology.
FIG. 7 is a partial side view of a display apparatus according to yet another embodiment of the disclosed technology.
FIG. 8A and FIG. 8B are graphs depicting color differences of a light emitting apparatus and a display apparatus according to the disclosed technology at different viewing location.

### [Best Mode]

In the following description, for the purposes of explanation, numerous specific details are set forth in order to provide thorough understanding of various exemplary embodiments or implementations of the disclosed technology. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Embodiments of the disclosed technology provide a light emitting apparatus including: a substrate 110; a cover layer 120 disposed on an upper surface of the substrate 110 and forming at least one opening 122 exposing at least a region of the upper surface of the substrate 110; a light emitting device 130 disposed on the upper surface of the substrate 110 exposed through the opening 122; and a molding layer 140 covering the cover layer 120 and the light emitting device 130. Hereinafter, exemplary embodiments of the disclosed technology will be described in more detail with reference to the accompanying drawings.

The substrate 110 is a circuit board having the light emitting device 130 mounted on an upper surface thereof and may include an insulating layer, wiring for electrical connection with the light emitting device 130, and circuitry for powering and driving the light emitting device 130.

The substrate 110 may be formed on an upper surface thereof with a pad to mount the light emitting device 130 thereon and on a lower surface thereof with another pad to be mounted on another substrate (not shown, for example, a display substrate).

The substrate 110 may be formed in a multilayer structure and in various thicknesses, as needed.

The cover layer 120 may be formed in various configurations forming at least one opening 122 that exposes at least a region of the upper surface of the substrate 110.

The cover layer 120 serves to cover at least a region of the upper surface of the substrate 110 and may be formed to closely contact the upper surface of the substrate 110.

The cover layer 120 may be an insulating layer.

When the cover layer 120 is formed with the opening 122 to expose a region of the upper surface of the substrate, the cover layer 120 may be formed on the upper surface of the substrate 110 through various processes. For example, the cover layer 120 may be formed on the upper surface of the substrate 100 through a photo solder resist (PSR) process.

Specifically, the cover layer 120 may be formed by applying ink to the upper surface of the substrate 110 (for example, by spraying or silk-screening), irradiating the deposited ink with light (UV) to cure the ink in a remaining region excluding a region corresponding to the opening 122 (exposure and curing), and removing the uncured region of the opening 122 to expose the upper surface of the substrate 110.

In addition, the cover layer 120 may include a black pigment. For example, the cover layer 120 may be a black PSR coating layer.

The opening 122 in the cover layer 120 serves to expose a mounting region, in which the light emitting device 130 is mounted on the upper surface of the substrate 110, and may be formed in various sizes and shapes.

The cover layer 120 may be formed with a plurality of opening 122 and at least one light emitting device 130 may be mounted in each opening 122. That is, one light emitting device 130 may be mounted in one opening 122 or a plurality of light emitting devices 130 may be mounted in one opening 122.

The light emitting device 130 includes a light emitting diode disposed on the upper surface of the substrate 110 exposed through the opening 122 and may be formed in various configurations.

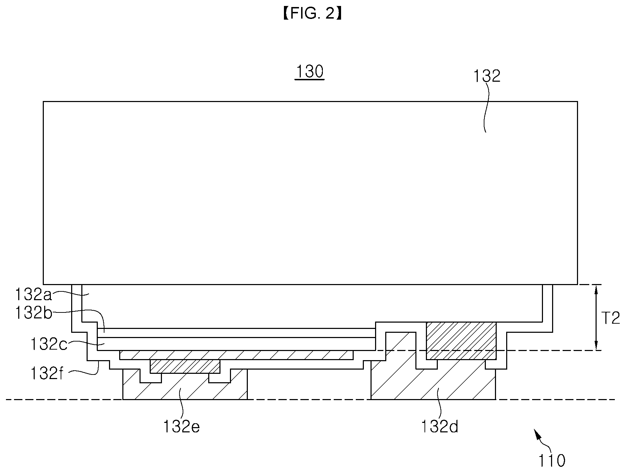

Referring to FIG. 2, the light emitting device 130 may include a transparent substrate 132 and a semiconductor layer 134 disposed on one surface of the transparent substrate 132 and generating light.

The transparent substrate 132 may be a light transmissive substrate, such as PET, a glass substrate, a quartz substrate, a sapphire substrate, or others.

The transparent substrate 132 is disposed on a light emitting surface of the light emitting device 130 and light emitted from the light emitting device 130 may be emitted through the transparent substrate 132.

The transparent substrate 132 may have an upper surface and a lower surface, and the semiconductor layer 134 may be disposed on the surface of the transparent substrate 132.

The semiconductor layer 134 refers to a light emitting structure configured to emit light having a predetermined peak wavelength and may be formed in various configurations.

For example, the semiconductor layer 134 may be a light emitting structure including a first conductivity type semiconductor layer 134a, an active layer 134b, and a second conductivity type semiconductor layer 134c.

The first conductivity type semiconductor layer 134a, the active layer 134b and the second conductivity type semiconductor layer 134c may be grown on a growth substrate in a chamber using a method known in the art, such as a metal organic chemical vapor deposition (MOCVD). The substrate may be selected from among a variety of substrates that can be used for semiconductor growth, such as a gallium nitride substrate, a GaAs substrate, a Si substrate, a sapphire substrate, particularly a patterned sapphire substrate. The growth substrate may be separated from semiconductor layers using a technique, such as mechanical polishing, laser lift-off, chemical lift-off, and the like. However, it should be understood that other implementations are possible and the substrate may partially remain to constitute at least a region of the first conductivity type semiconductor layer 21.

For the light emitting device 130 configured to emit red light, the semiconductor layers 134 may include aluminum gallium arsenide (AlGaAs), gallium arsenide phosphide (GaAsP), aluminum gallium indium phosphide (AlGaInP), or gallium phosphide (GaP).

For the light emitting device 130 configured to emit green light, the semiconductor layers 134 may include indium gallium nitride (InGaN), gallium nitride (GaN), gallium phosphide (GaP), aluminum gallium indium phosphide (AlGaInP), or aluminum gallium phosphide (AlGaP).

For the light emitting device 130 configured to emit blue light, the semiconductor layer may include gallium nitride (GaN), indium gallium nitride (InGaN), or zinc selenide (ZnSe).

The first conductivity type semiconductor layer 134a and the second conductivity type semiconductor layer 134c have opposite polarity to each other. When the first conductive type is n-type, the second conductive type is p-type, and when the first conductive type is p-type, the second conductive type is n-type.

For example, the first conductivity type semiconductor layer 134a may include n-type dopants (for example, Si, Ge, Sn, or others) and the second conductivity type semiconductor layer 134c may include p-type dopants (for example, Mg, Sr, Ba, or others).

Specifically, the first conductivity type semiconductor layer 134a may include GaN or AlGaN containing Si as a dopant and the second conductivity type semiconductor layer 134c may include GaN or AlGaN containing Mg as a dopant.

Although each of the first conductivity type semiconductor layer 134a and the second conductivity type semiconductor layer 134c is shown as a single layer in the drawings, these layers may have a multilayer structure and may also include a superlattice layer.

The active layer 134b may include a single quantum well structure or a multiquantum well structure (MQW), and the composition of a nitride semiconductor of the active layer 134b may be adjusted to emit a desired wavelength. For example, the light emitting device 130 may be configured to emit blue light, green light, red light, or ultraviolet light from the active layer 134b.

The second conductivity type semiconductor layer 134c and the active layer 134b may be disposed on the first conductivity type semiconductor layer 134a to have a mesa structure.

The mesa may include the second conductivity type semiconductor layer 134c and the active layer 134b, and may include a region of the first conductivity type semiconductor layer 134a. The mesa may be placed over a region of the first conductivity type semiconductor layer 134a and an upper surface of the first conductivity type semiconductor layer 21 may be exposed around the mesa.

The light emitting device 130 may include an insulating layer 134f that covers the first conductivity type semiconductor layer 134a and the second conductivity type semiconductor layer 134c and forms openings in which the two electrode pads 134d, 134e are disposed.

The two electrode pads 134d, 134e may be electrically connected to the first conductivity type semiconductor layer 134a and the second conductivity type semiconductor layer 134c through the openings in the insulating layer 134f, respectively.

The electrode pads 134d, 134e may be formed in a single layer or multilayer structure using a metal. The electrode pads 134d, 134e may be formed of a metal, such as Al, Ti, Cr, Ni, Au, or alloys thereof.

The two electrode pads 134d, 134e may be electrically connected to electrode pads formed on the upper surface of the substrate 110.

Although the light emitting device 130 according to the embodiment of the disclosed technology has been briefly described with reference to the accompanying drawings, the light emitting device 130 may further include layers having additional functions in addition to the layers described above. For example, the light emitting device 130 may further include a reflective layer to reflect light, an additional insulating layer to insulate certain components, an anti-solder layer to prevent diffusion of solder, an ohmic layer, a contact layer, or others.

In addition, the light emitting device 130 may form a mesa in various shapes and the locations or shape of the electrode pads 134d, 134e may also be modified in various ways. Further, the light emitting device 130 is not limited to a flip-chip structure.

Although the light emitting device 130 may include a single light emitting structure configured to emit light having a single peak wavelength, it should be understood that other implementations are possible. Alternatively, a red light emitting structure, a blue light emitting structure, and a green light emitting structure may be vertically stacked one above another or may horizontally disposed to form a single light emitting device 130.

Although FIG. 2 illustrates an example in which one semiconductor layer 134 is disposed on one transparent substrate 132 and each light emitting device 130 has a separate transparent substrate 132, it should be understood that other implementations are possible and a plurality of semiconductor layers 134 may also be formed on one transparent substrate 132.

On the other hand, as the light emitting devices 130 are mounted on the upper surface of the substrate 110 exposed through the openings 122 of the coating layer 120, the openings 122 may have various sizes and shapes depending on the number of light emitting devices 130 mounted within the openings 122 and the size and shape of the light emitting devices 130, when viewed in plan view.

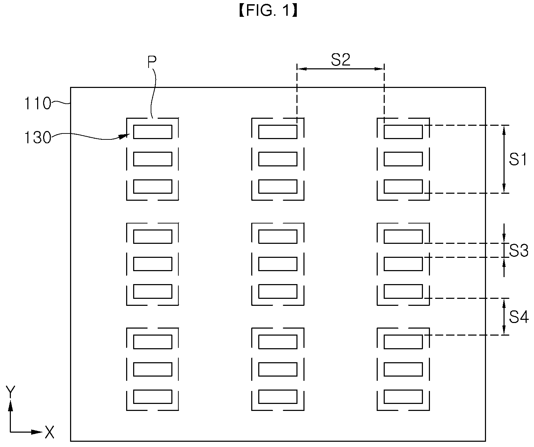

For example, referring to FIG. 1, the opening 122 may be formed in a rectangular shape having a length K1 in the X-axis direction and a length K2 in the Y-axis direction perpendicular to the X-axis direction in plan view, without being limited thereto.

The length K1 of the opening 122 in the X-axis direction and the length K2 of the opening 122 in the Y-axis direction may be varied depending on the number of light emitting devices 130 mounted within the opening 122, a length W1 of the light emitting device 130 in the X-axis direction, and a length W2 of the light emitting device 130 in the Y-axis direction.

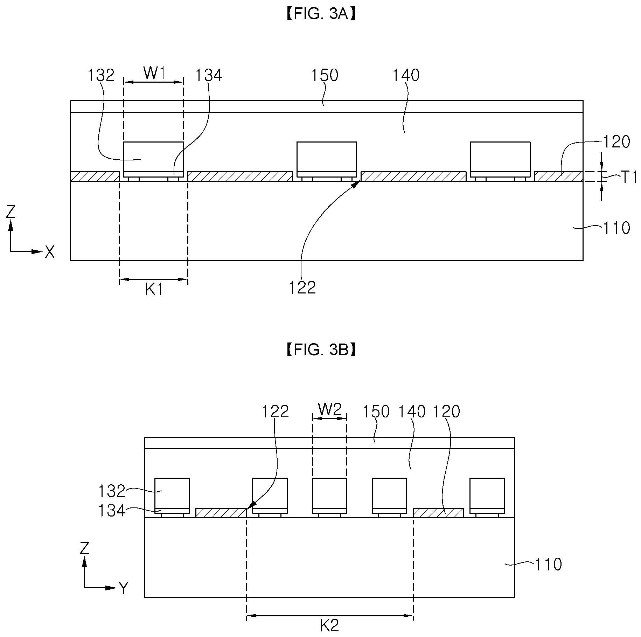

In a single opening 122, a single light emitting device 130 or a plurality of light emitting devices 130 may be disposed at regular intervals. FIG. 3A and FIG. 3B illustrate an example in which three light emitting devices 130 linearly arranged at regular intervals within a single opening 122, and the cover layer 120 may form a boundary that encloses an outer periphery of three neighboring light emitting devices 130.

Although FIG. 3 to FIG. 6 illustrate an example in which both the length K1 and the length K2 of the opening 122 in the X-axis direction and in the Y-axis direction, respectively, are formed greater than the corresponding lengths of the light emitting device 130 such that a gap is formed between the cover layer 120 and the light emitting device 130, it should be understood that other implementations are possible.

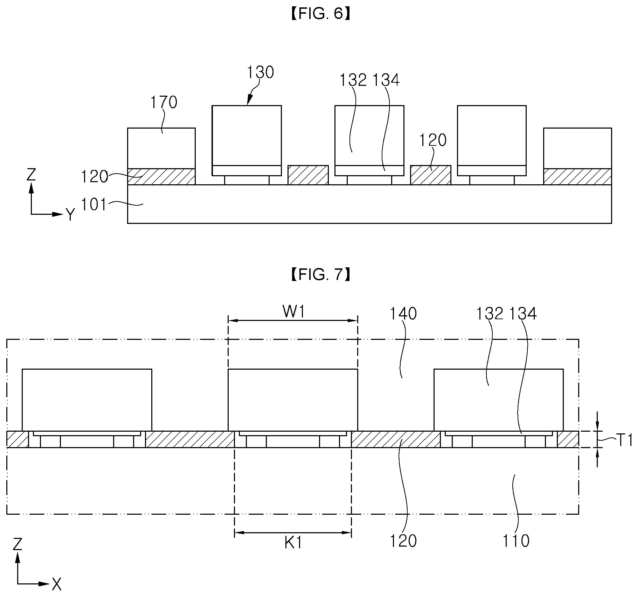

For example, in a structure that the electrodes 134d, 134e formed on a lower surface of the light emitting device 130 are placed within the opening 122, as shown in FIG. 7, the opening 122 may have a smaller size than the light emitting device 130.

Referring to FIG. 7, with the structure in which the length K1 of the opening 122 in the X-axis direction is less than the length W1 of the light emitting device 130 in the X-axis direction such that the opening 122 has a smaller size than the emitting device 130, the light emitting device 130 can advantageously be more precisely mounted within the opening 122.

The cover layer 120 has a thickness T1 corresponding to a length from the upper surface of the substrate 110 to an upper surface of the cover layer 1200 and may be formed substantially thinner than the light emitting device 130. Here, the thickness T1 of the cover layer 120 may be greater than a thickness T2 of the semiconductor layer 134 of the light emitting device 130.

Furthermore, the upper surface of the cover layer 120 may be placed at a location corresponding to or higher than the upper surface of the semiconductor layer 134. With this structure, the light emitting apparatus allows light emitted from a side surface of the semiconductor layer 134 to be blocked by the cover layer 120 and emitted upwards, thereby improving color clarity.

The molding layer 140 serves to cover the cover layer 120 and the light emitting device 130 and may be formed in various configurations.

The molding layer 140 may be formed in a single layer or multilayer structure.

In one embodiment, when the molding layer 140 is formed in a single layer structure, as shown in FIG. 3A and FIG. 3B, the molding layer 140 may be formed as a light transmitting layer, such as a translucent layer or a transparent layer for light emission. For example, the molding layer 140 may be formed by applying a transparent resin (for example, an epoxy resin, a silicone resin, or others) to the upper surface of the substrate 110, followed by curing the transparent resin.

The molding layer 140 may include a light transmissive material and may further include a light diffusing material for light diffusion. When the molding layer 140 includes the light diffusing material, light generated by the light emitting device 130 can be diffused and emitted through the molding layer 140 upon emission of the light through the top of the light emitting device 130, thereby allowing uniform diffusion of the light in the light emitting apparatus.

Furthermore, the molding layer 140 may have a light transmittance that varies depending on the content of a diffusing agent for light diffusion. Thus, the thickness of the molding layer 140 may be determined in consideration of light transmittance.

Although an upper surface of the molding layer 140 is shown as being flat in FIG. 3A, a plurality of irregularities may be formed on the upper surface of the molding layer 140 to form roughness thereon.

A film layer 150 may be disposed on the upper surface of the molding layer 140.

The film layer 150 may be an anti-glare layer capable of preventing glare.

By way of example, the film layer 150 may be formed through matte treatment. Specifically, the film layer 150 may be a matte film layer that is attached to the upper surface of the molding layer 140 and then subjected to surface treatment.

The film layer 150 may be formed thinner than the molding layer 140 and may have various thicknesses depending on the thickness of the film attached to the upper surface of the molding layer 140. It should be understood that films having various thicknesses may be selectively attached.

An adhesive layer for film adhesion may be disposed between the film layer 150 and the molding layer 140.

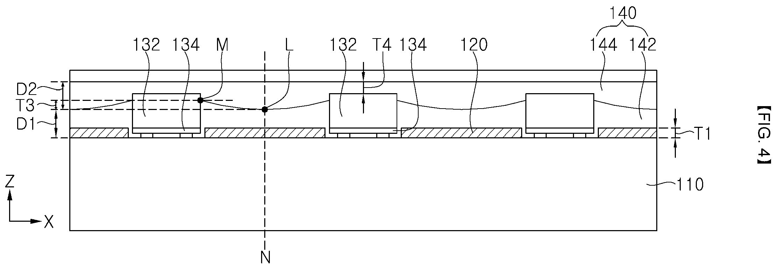

In another embodiment, when the molding layer 140 is formed in a multilayer structure as shown in FIG. 4, the molding layer 140 may include a first molding layer 142 that covers at least a region of a side surface of the light emitting device 130 while exposing the upper surface of the light emitting device 130, and a second molding layer 142 that covers the upper surface of the light emitting device 130 and the first molding layer 142.

The first molding layer 142 covers at least a region of the side surface of the light emitting device 130 while exposing the upper surface of the light emitting device 130, and may include a light reflective material or a light absorbing material.

The first molding layer 142 may be an opaque layer and may include a black pigment to adjust contrast of a display.

The first molding layer 142 may be formed by applying a molding agent to the top of the substrate 110, followed by pressing and high temperature treatment to liquefy the molding agent such that the molding agent fills around the light emitting device 130. Alternatively, the first molding layer 142 may be formed by curing a resin through UV treatment.

The first molding layer 142 may perform a light blocking function and may further perform both a light blocking function and a light reflecting function. For example, the first molding layer 142 may be formed of a carbon black molding agent or a white-black combined molding agent.

However, it should be understood that other implementations are possible and the first molding layer 142 may further perform a light absorbing function in addition to a light reflecting function. For example, the first molding layer 142 may be formed of a white molding agent or a white-black combined molding agent. Accordingly, the contrast of light emitted through the first molding layer 142 can be adjusted and brightness of the display can be improved.

As the first molding layer 142 includes at least one of a light blocking material or a light reflective material, the first molding layer 142 may expose at least a region of the upper surface of the light emitting device 130. That is, the first molding layer 142 may be formed so as not to cover the entirety of the upper surface of the light emitting device 13 and may be disposed to cover at least a region of the side surface of the light emitting device 13.

Here, the first molding layer 142 may cover the entirety of the side surface of the light emitting device 130 or may be formed at a lower height than the light emitting device 130 so as not to cover a portion of an upper region of the side surface of the light emitting device 130.

As the first molding layer 142 is disposed to cover at least a region of the side surface of the light emitting device 130 without covering the upper surface thereof, light generated by the light emitting device 130 and directed toward the side surface thereof may be reflected from the first molding layer 142 and guided to be emitted in an upward direction. Thus, the light emitting apparatus can achieve improvement in luminous efficacy and luminance by increasing light extraction in the upward direction.

A lower space of the light emitting device 130, that is, a space between the electrode pads 134d, 134e, may also be filled with the first molding layer 142. Accordingly, when light generated by the light emitting device 130 is directed downwards, the first molding layer 142 can reflect and guide the light to be emitted in the upward direction. Thus, light extraction efficiency and luminance uniformity of the light emitting apparatus can be further improved. It should be understood that the lower space of the light emitting device 130 may be filled with air instead of the first molding layer 142.

Although FIG. 4 shows the first molding layer 142 formed to expose the entirety of the upper surface of the light emitting device 130, the first molding layer 142 may be formed to expose only a region of the upper surface of the light emitting device 130.

By way of example, the first molding layer 142 may expose a central region of the upper surface of the light emitting device 130 and may extend to an edge of the upper surface of the light emitting device 130 to overlap at least a region of the region of the upper surface (corner side) of the light emitting device 130.

On the other hand, the first molding layer 142 is formed by curing the resin applied to the upper surface of the substrate 110 and an upper surface of the first molding layer 142 disposed between adjacent light emitting devices 130 may form a curved surface under influence of surface tension of a liquid material.

Depending on the amount of the molding agent applied to the substrate, the upper surface of the first molding layer 142 may form a concave surface, which may have the lowest point L and the highest point M.

Referring to FIG. 4, with reference to an imaginary vertical line N passing through the lowest point L, the concave surface may be formed in a left-right asymmetrical shape and may also be formed to have different curvatures at right and left sides thereof.

The second molding layer 144 is a light transmitting layer covering the upper surfaces of the first molding layer 142 and the light emitting device 130, and may be formed in various configurations.

The second molding layer 144 may be formed as a translucent or transparent layer for light emission. For example, the second molding layer 144 may be formed by applying a transparent resin (for example, an epoxy resin, a silicone resin, and the like) to the upper surfaces of the first molding layer 142 and the light emitting device 130, followed by curing the transparent resin.

The second molding layer 144 includes a light transmissive material and may further include a light diffusing material for light diffusion. When the second molding layer 144 includes the light diffusing material, light generated by the light emitting device 130 and directed in the upward direction can be diffused and emitted through the second molding layer 144 upon emission of the light through the top of the light emitting device 130, thereby allowing uniform diffusion of the light in the light emitting apparatus.

Furthermore, the second molding layer 144 may have a light transmittance that varies depending on the content of a diffusing agent for light diffusion. Thus, the thickness of the second molding layer 144 may be determined in consideration of the light transmittance.

Although the upper surface of the second molding layer 144 is shown as being flat in FIG. 4, a plurality of irregularities may be formed on the upper surface of the second molding layer 144 to form roughness thereon.

A film layer 150 having the same or similar configuration to the film layer described above may be disposed on an upper surface of the second molding layer 144.

In the embodiment shown in FIG. 4, a thickness D1 from the upper surface of the substrate 110 to the lowest point L of the concave surface of the first molding layer 142 may be greater than a thickness D2 from the lowest point L of the concave surface of the first molding layer 142 to the upper surface of the second molding layer 144.

In addition, a thickness T1 of the cover layer 120 may be greater than a thickness T3 from the lowest point L of the concave surface of the first molding layer 142 to the highest point M of the concave surface thereof. Further, the thickness T1 of the cover layer 120 may be less than a thickness from an upper surface of the cover layer 120 to the lowest point L of the concave surface of the first molding layer 142.

Furthermore, a long axis width W1 of the light emitting device 130 may be greater than a thickness T4 from the upper surface of the light emitting device 130 to the upper surface of the second molding layer 144. This structure can maximize the light extraction efficiency of light emitted from the light emitting device 130 as it passes through the second molding layer 144.

In addition, a thickness from the upper surface of the substrate 110 to the upper surface of the light emitting device 130 may be greater than the thickness T4 from the upper surface of the light emitting device 130 to the upper surface of the second molding layer 144. Here, the thickness from the upper surface of the substrate 110 to the upper surface of the light emitting device 130 may be less than or equal to 2 times a thickness T2 from the upper surface of the second molding layer 144 to the upper surface of the light emitting device 130.

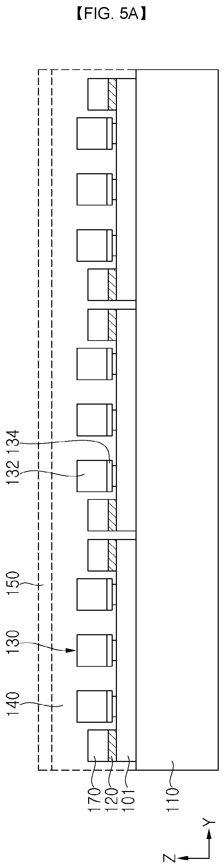

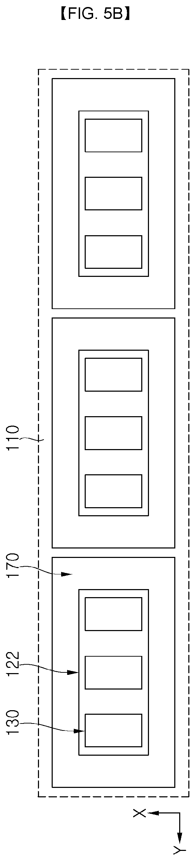

Next, FIG. 5 shows a light emitting apparatus according to another embodiment of the disclosed technology, which is different from the light emitting apparatuses shown in FIG. 3A to FIG. 4 in that one or more light emitting devices 130 are mounted on the substrate 110 through a sub-board 101.

In this embodiment, the light emitting devices 130 are directly mounted on the sub-board 101, which in turn is disposed on the upper surface of the substrate 110, and handling of the sub-board can be easier than handing of the light emitting devices 130 which are individually disposed on the substrate 110. That is, when a plurality of light emitting devices 130 is disposed on a single sub-board 101, the plurality of light emitting devices 130 can be mounted on the substrate 110 by handling only one sub-board 101.

In the light emitting apparatus shown in FIG. 5, the cover layer 120 may be formed on the sub-board 101 to be disposed on the substrate 110.

Referring to FIG. 5A and FIG. 5B, the cover layer 120 may be formed along an edge of the sub-board 101 to define a single opening 122 therein. A plurality of light emitting devices 130 may be disposed within the opening 122. Alternatively, referring to FIG. 6, the cover layer 120 may define a plurality of openings 122 therein such that one light emitting device 130 is disposed in each of the openings 122.

The molding layer 140 described above may be formed on the upper surfaces of the cover layer 120 and the light emitting device 130

A separate light control layer 170 may be further formed on the cover layer 120, as shown in FIG. 5A to FIG. 6.

The light control layer 170 may be formed along the edge of the sub-board 101 so as to have a dam shape. Although the light control layer 170 has a greater thickness than the cover layer 120, an upper surface of the light control layer 170 may be placed lower than the upper surface of the light emitting device 130. Although not shown in the drawings, the upper surface of the light control layer 170 may be placed higher than the upper surface of the light emitting device 130 in another embodiment.

The light control layer 170 may perform a light blocking function and may further perform both a light blocking function and a light reflecting function.

For example, the light control layer 170 may be formed of a carbon black molding agent or a white-black combined molding agent. However, it should be understood that other implementations are possible and the light control layer 170 may further perform a light absorbing function in addition to the light reflecting function. For example, the light control layer 170 may be formed of a white molding agent or a white-black combined molding agent. Accordingly, the contrast of light emitted through the light control layer 170 can be adjusted and brightness of a display can be improved.

Referring to FIG. 1, the light emitting apparatus according to the disclosed technology may include three light emitting devices 130 configured to emit light with different peak wavelengths and disposed in a first direction on a plane to form one pixel P. Here, the first direction may be the Y-axis direction with reference to FIG. 1 and, as a second direction, a direction perpendicular to the first direction may be the X-axis direction with reference to FIG. 1.

The three light emitting devices 130 constituting one pixel P may be light emitting diodes that emit red, green, and blue light, respectively.

Referring to FIG. 1, the light emitting apparatus may include a plurality of pixels P arranged in a matrix in the first direction and the second direction perpendicular to the first direction. The plurality of pixels P may be disposed in a plane to allow uniform emission of light.

Specifically, the maximum distance S1 between two light emitting devices 130 at opposite ends within the pixel P in the first direction may be greater than the shortest distance S2 between two adjacent pixels P in the second direction.

Furthermore, a separation distance S3 between two adjacent light emitting devices 130 within the pixel P in the first direction may be smaller than the shortest distance S4 between two adjacent pixels P in the first direction.

The red, green and blue light emitting devices 130 that constitute one pixel P may be managed to have a light intensity ratio (for example, RGB ratio of 3:6:1), a peak wavelength, and a dominant wavelength in accordance with the maximum visual sensitivity wavelength of 550 nm.

Specifically, the light emitting device 130 configured to emit blue light B may be a blue light emitting diode having a peak wavelength within the blue wavelength band. The blue light emitting diode may have a difference of 2 nm to 15 nm between the peak wavelength and the dominant wavelength of the blue light emitting diode. Specifically, the blue light emitting diode may have a peak wavelength of 455 nm to 475 nm and a dominant wavelength of 460 nm to 480 nm. The peak wavelength of the blue light emitting diode may be shorter than the dominant wavelength thereof.

The light emitting device 130 configured to emit green light G may be a green light emitting diode having a peak wavelength within the green wavelength band. The green light emitting diode may have a difference of 5 nm and 20 nm between the peak wavelength and the dominant wavelength thereof. Specifically, the green light emitting diode may have a peak wavelength of 520 nm to 540 nm and a dominant wavelength of 525 nm to 545 nm. The peak wavelength of the green light emitting diode may be shorter than the dominant wavelength thereof.

The light emitting device 130 configured to emit red light R may be a red light emitting diode having a peak wavelength within the red wavelength band. The red light emitting diode may have a difference of 5 nm to 20 nm between the peak wavelength and the dominant wavelength thereof. Specifically, the red light emitting diode may have a peak wavelength of 620 nm to 640 nm and a dominant wavelength of 610 nm and 630 nm. The peak wavelength of the red light emitting diode may be longer than the dominant wavelength.

Each of the light emitting devices 130 may have a different deviation of the peak wavelength and the dominant wavelength thereof. For example, the deviation of the peak wavelength and the dominant wavelength of the blue light emitting diode may be smaller than the deviation of the peak wavelength and the dominant wavelength of the green light emitting diode. The deviation of the peak wavelength and the dominant wavelength of the green light emitting diode may be smaller than the deviation of the peak wavelength and the dominant wavelength of the red light emitting diode. In this way, by managing the deviation of the peak wavelength and the dominant wavelength of each of the blue light emitting diode, the green light emitting diode, and the red light emitting diode, it is possible to improve the color purity and visual sensitivity of the colors that form the image on the display.

Furthermore, the light emitting apparatus according to the disclosed technology includes the substrate 110, the cover layer 120, and the molding layer 140, and may be configured through various combinations with at least one of other components, for example, the film layer 150, the light control layer 170, and the sub-board 101.

The shape, thickness T1, material, and opening 122 of the cover layer 120 may be independent of the other components.

The molding layer 140 may have a single layer structure or a multilayer structure, and even with the structure wherein the molding layer 140 has a multilayer structure (including first and second molding layers 142, 144), the light emitting apparatus may further include the light control layer 170 described above. The material, added fillers, thickness, and layer structure of the molding layer 140 may be independent of the other components.

Even in the light emitting apparatus including the sub-board 101, the cover layer 120 and the molding layer 140 described with reference to FIG. 3A to FIG. 4 may be applied thereto in the same way or in a similar way.

The light emitting apparatus according to various embodiments of the disclosed technology described above may constitute a display apparatus. The light emitting apparatus described above may be a display module and the display apparatus may include at least one display module.

Specifically, the display apparatus includes at least one display module. Here, the display module includes a substrate 110, a cover layer 120 disposed on an upper surface of the substrate 110 and forming at least one opening 122 that exposes at least a region of the upper surface of the substrate 110, a light emitting device 130 disposed on the upper surface of the substrate 110 exposed through the opening 122, and a molding layer 140 covering the cover layer 120 and the light emitting device 130.

In constitution of the display apparatus, side surfaces of a plurality of display modules may be disposed to contact each other, thereby realizing display screens having various sizes.

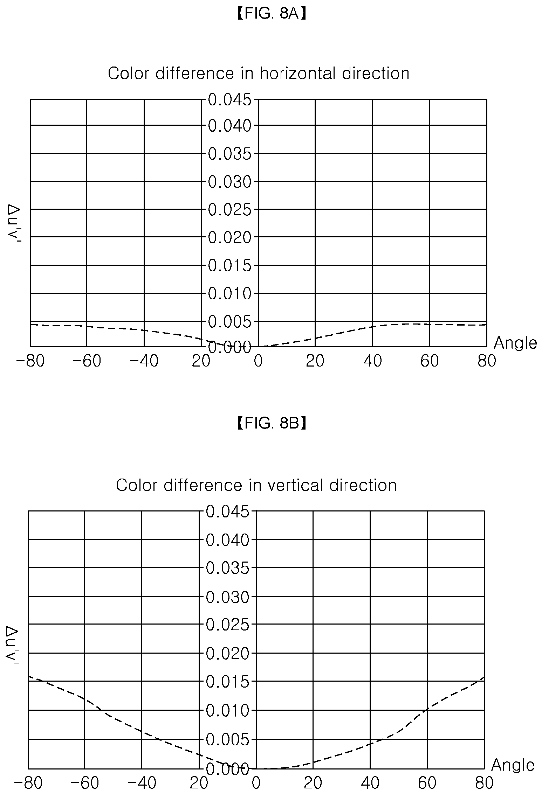

FIG. 8A to FIG. 8B are graphs showing color differences of a light emitting apparatus and a display apparatus according to the disclosed technology at different viewing location. And it can be seen that the color difference at a viewing angle of -60° to +60° is less than or equal to 0.002 in the horizontal direction and is less than or equal to 0.015 in the vertical direction. This confirms that the uniformity of luminance and color by location has been significantly improved.

Although some exemplary embodiments have been described herein with reference to the accompanying drawings, it should be understood that various modifications and changes can be made by those skilled in the art or by a person having ordinary knowledge in the art without departing from the spirit and scope of the invention, as defined by the claims and equivalents thereto.

Therefore, the scope of the invention should be defined by the appended claims and equivalents thereto instead of being limited to the detailed description of the invention.

## Claims

1. A light emitting apparatus comprising:
a substrate;
a cover layer disposed on an upper surface of the substrate and forming at least one opening exposing at least a region of the upper surface of the substrate;
a light emitting device disposed on the upper surface of the substrate exposed through the opening; and
a molding layer covering the cover layer and the light emitting device.

2. The light emitting apparatus according to claim 1, wherein the cover layer is a coating layer including a black pigment.

3. The light emitting apparatus according to claim 1, wherein
the light emitting device includes a transparent substrate and a semiconductor layer disposed on one surface of the transparent substrate to generate light, and
the cover layer has a greater thickness than the semiconductor layer.

4. The light emitting apparatus according to claim 1, wherein the opening has a smaller size than the light emitting device in plan view.

5. The light emitting apparatus according to claim 1, wherein the molding layer includes:
a first molding layer covering at least a region of a side surface of the light emitting device while exposing an upper surface of the light emitting device; and
a second molding layer covering the upper surface of the light emitting device and the first molding layer.

6. The light emitting apparatus according to claim 5, wherein the first molding layer includes at least one of a light reflective material or a light absorbing material.

7. The light emitting apparatus according to claim 5, wherein the second molding layer is a light transmitting layer.

8. The light emitting apparatus according to claim 5, wherein an upper surface of the first molding layer disposed between two adjacent light emitting devices forms a concave surface.

9. The light emitting apparatus according to claim 5, wherein a thickness from the upper surface of the substrate to the lowest point of the concave surface of the first molding layer is greater than a thickness from the lowest point of the concave surface of the first molding layer to an upper surface of the second molding layer.

10. The light emitting apparatus according to claim 5, wherein a thickness of the cover layer is greater than a thickness from the lowest point of the concave surface of the first molding layer to the highest point of the concave surface of the first molding layer.

11. The light emitting apparatus according to claim 5, wherein a long axis width of the light emitting device is greater than a thickness from the upper surface of the light emitting device to an upper surface of the second molding layer.

12. The light emitting apparatus according to claim 1, wherein three light emitting devices configured to emit light with different peak wavelengths and disposed in a first direction on a plane form one pixel,
the light emitting apparatus includes a plurality of pixels arranged in a matrix in the first direction and a second direction perpendicular to the first direction.

13. The light emitting apparatus according to claim 12, wherein a maximum distance between two light emitting devices at opposite sides within the pixel in the first direction is greater than the shortest distance between two adjacent pixels in the second direction.

14. The light emitting apparatus according to claim 12, wherein a separation distance between two adjacent light emitting devices within the pixel in the first direction is smaller than the shortest distance between two adjacent pixels in the first direction.
